# EUROPEAN PATENT APPLICATION

(11) **EP 1 976 123 A1**
(43) Date of publication of application: **01.10.2008**
(21) Application number: 07707078.7
(22) Date of filing: 19.01.2007
(51) Int. Cl.: H03K 3/03, G09G 3/20, G09G 3/36

(54) **OSCILLATION CIRCUIT, POWER SOURCE CIRCUIT, DISPLAY DEVICE, AND ELECTRONIC DEVICE**

(30) Priority: 20.01.2006 JP 2006013110
(71) Applicant: Sony Corporation, Minato-ku Tokyo (JP)
(72) Inventor: TAKAHASHI, Yusuke, Minato-ku Tokyo (JP); KIDA, Yoshitoshi, Minato-ku Tokyo (JP); NAKAJIMA, Yoshiharu, Minato-ku Tokyo (JP)
(74) Representative: Thévenet, Jean-Bruno
(86) International application number: PCT/JP2007/050790
(87) International publication number: WO 2007/083742

(57) **Abstract**

An oscillation circuit, power supply circuit, display device using same, and electronic apparatus which can be built in a display panel without causing an increase of cost and do not need any adjustment work, each having a pulse generation portion (161) formed by an oscillator outputting rectangular wave signals having a frequency variation and a frequency variation correction portion (162) for suppressing output rectangular waves of the pulse generation portion (161) within a certain frequency range and outputting the same to a boosting circuit (163), wherein the frequency variation correction portion (162) includes an input pulse counter (1621) having n number of counters cascade connected and counting numbers of high level and low level periods of rectangular waves input from the pulse generation portion within a comparison input period, a counter value comparison circuit (1622) for generating a selection signal for selecting a last output from any counter among the cascade connected counters when the input pulse counter counts any number, and an output selection circuit (1623) for receiving the selection signal and outputting a corresponding counter value.

## Description

### TECHNICAL FIELD

The present invention relates to an oscillation circuit formed by low temperature polysilicon thin film transistors formed on an insulation substrate, a power supply circuit, a liquid crystal display device or other active matrix type display devices, and an electronic apparatus using the same.

### BACKGROUND ART

In recent years, mobile phones, PDA (personal digital assistants), and other portable terminals have remarkably spread. As one of factors of the rapid spread of these portable terminals, the liquid crystal display devices mounted as their output displays can be mentioned. The reason is that liquid crystal display devices have the feature that they do not in principle require electric power for being driven and therefore are low power consumption display devices.

In active matrix type display devices using polysilicon TFTs (thin film transistors) as switching elements of pixels, the tendency is to integrally form the digital interface drive circuit on the same substrate as the display area where the pixels are arranged in a matrix.
In such an integral drive circuit type display device, a horizontal drive system and a vertical drive system are arranged at a periphery (frame) of an effective display portion. These drive systems are integrally formed on the same substrate together with the pixel area using low temperature polysilicon TFTs.

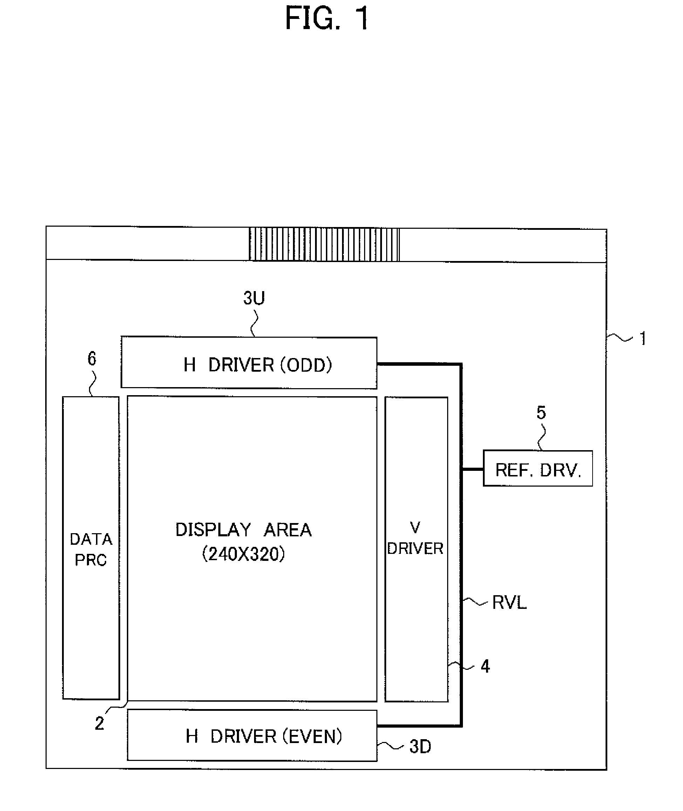

FIG. 1 is a diagram showing the schematic configuration of a general integral drive circuit type display device (see for example Patent Document 1).

This liquid crystal display device, as shown in FIG. 1, is comprised of a transparent insulation substrate, for example a glass substrate 1, on which an effective display portion 2 having a plurality of pixels including liquid crystal cells arranged in a matrix, a pair of horizontal drive circuits (H drivers) 3U and 3D arranged above and below the effective display portion 2 in FIG. 1, a vertical drive circuit (V driver) 4 arranged at a side portion of the effective display portion 2 in FIG. 1, one reference voltage generation circuit (REF.DRV) 5 for generating a plurality of reference voltages, a data processing circuit (DATAPRC)6, etc. are integrated.

In this way, the integral drive circuit type display device of FIG. 1 has two horizontal drive circuits 3U and 3D arranged on the two sides (above and below in FIG. 1) of the effective pixel portion 2. This is in order to drive the data lines divided in odd number lines and even number lines.

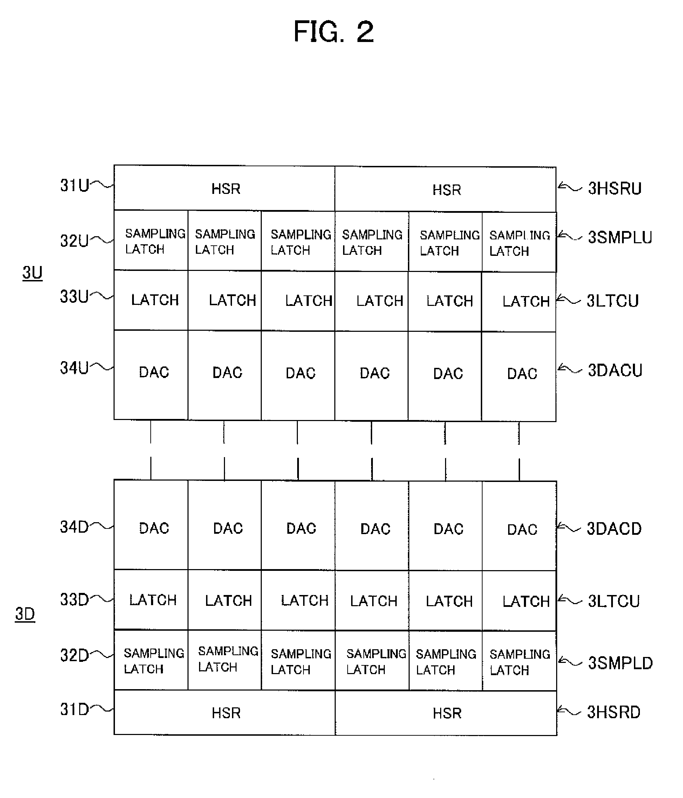

FIG. 2 is a block diagram showing an example of the configuration of the horizontal drive circuits 3U and 3D for separately driving odd number lines and even number lines.

As shown in FIG. 2, the horizontal drive circuit 3U for driving the odd number lines and the horizontal drive circuit 3D for driving the even number lines have the same configuration.
Specifically, they have shift register (HSR) groups 3HSRU and 3HSRD for sequentially outputting shift pulses (sampling pulses) from transfer stages in synchronization with horizontal transfer clocks HCK (not shown), sampling and latch circuit groups 3SMPLU and 3SMPLD for sequentially sampling and latching digital image data by sampling pulses given from shift registers 31U and 31D, linear sequencing latch circuit groups 3LTCU and 3LTCD for linearly sequencing latch data of sampling and latch circuits 32U and 32D, and digital/analog conversion circuit (DAC) groups 3DACU and 3DACD for converting digital image data linearly sequenced at the linear sequencing latch circuits 33U and 33D to analog image signals.
Note that, usually, at input stages of DAC 34U and DAC 34D, level shift circuits are arranged, and level up data are input to the DACs 34.
Patent Document 1: Japanese Patent Publication (A) No. 2002-175033

### DISCLOSURE OF THE INVENTION

### PROBLEM TO BE SOLVED BY THE INVENTION

The liquid crystal display device of FIG. 1 etc. is configured so as to level shift (boost up) a voltage supplied from the outside by a power supply circuit configured by a DC-DC converter in synchronization with a master clock MCK of a predetermined level from for example the outside to generate a drive voltage inside a panel and supply the drive voltage to an intended circuit formed on an insulation substrate.

However, in an existing low terminal polysilicon TFT, the threshold voltage Vth rises up to about 1.5V at the time of rise again.
Accordingly, when a synchronization pulse becomes a low voltage/high frequency, a level shift and frequency division become difficult inside a panel formed by a low temperature polysilicon TFT process.

Other than that, as the integration scale becomes larger, a variety of problems arise in a synchronization type system controlling an overall system by one synchronization pulse.
In the synchronization type system, not only is the processing speed of the overall system limited to that of the slowest circuit, but also even blocks which do not have to perform processing consume electric power. Note that, in a large scale system, the amount of delay of the synchronization pulse due to the interconnects between the separated blocks becomes significant. Therefore, it is not to say that the blocks can strictly be synchronized. Overall logic verification becomes difficult.
In order to deal with this, configuration of a circuit system which can be controlled by a unique oscillation frequency without being influenced by the synchronization pulse, that is, an asynchronous system having an oscillator for each block, becomes necessary.

However, configuration of an oscillator for synchronization pulse generation having a small frequency variation in the low temperature polysilicon TFT process is difficult.
For example, when configuring an RC oscillator or ring oscillator used as an oscillator in the silicon process by a low temperature polysilicon process, it is difficult to keep an output frequency thereof within a certain assumed allowable range.
It is possible to configure an oscillator outside the panel, but several elements including frequency adjustment parts become necessary, so this causes an increase of the TAT and an increase of the cost.

The present invention provides an oscillation circuit and a power supply circuit which can be built in a display panel etc. without causing an increase of cost and which do not need adjustment work, a display device using the same, and an electronic apparatus.

### MEANS FOR SOLVING THE PROBLEM

A first aspect of the present invention is an oscillation circuit including low temperature polysilicon thin film transistors formed on an insulation substrate, having a pulse generation portion including an oscillator for generating pulse signals having a frequency variation and a frequency variation correction portion for outputting output rectangular waves of the pulse generation portion suppressed to a predetermined frequency range, wherein the frequency variation correction portion includes an input pulse counter having n number of counters cascade connected and counting numbers of high level and low level periods of rectangular waves input from the pulse generation portion in a comparison input period, a counter value comparison circuit for generating a selection signal for selecting a last output from an any counter among the cascade connected counters when the input pulse counter counts any number, and an output selection circuit for receiving the selection signal and outputting a corresponding counter value.

A second aspect of the present invention is a power supply circuit for boosting up a predetermined voltage based on an output of an oscillation circuit including low temperature polysilicon thin film transistors formed on an insulation substrate, wherein the oscillation circuit has a pulse generation portion including an oscillator for generating pulse signals having a frequency variation and a frequency variation correction portion for outputting output rectangular waves of the pulse generation portion suppressed to a predetermined frequency range, wherein the frequency variation correction portion includes an input pulse counter having n number of counters cascade connected and counting numbers of high level and low level periods of rectangular waves input from the pulse generation portion in a comparison input period, a counter value comparison circuit for generating a selection signal for selecting a last output from an any counter among the cascade connected counters when the input pulse counter counts any number, and an output selection circuit for receiving the selection signal and outputting a corresponding counter value.

Preferably, the input pulse counter starts a count operation by a release of reset and ends the variation correction at the time of the next reset.

Preferably, frequency correction results with respect to input rectangular waves are held until the reset is applied.

Preferably, according to a combination of logics in the counter value comparison circuit, determination of the lowest/highest value of the output frequency and ratio adjustment thereof are possible.

A display device of a third aspect of the present invention includes at least a display portion having pixels arranged in a matrix, a drive circuit for driving the display portion, and a power supply circuit for boosting up a predetermined voltage and generating a drive voltage inside the substrate based on the output of the oscillation circuit including low temperature polysilicon thin film transistors formed on an insulation substrate, wherein the oscillation circuit has a pulse generation portion including an oscillator for generating pulse signals having a frequency variation and a frequency variation correction portion for outputting output rectangular waves of the pulse generation portion suppressed to a predetermined frequency range, wherein the frequency variation correction portion includes an input pulse counter having n number of counters cascade connected and counting numbers of high level and low level periods of rectangular waves input from the pulse generation portion in a comparison input period, a counter value comparison circuit for generating a selection signal for selecting a last output from an any counter among the cascade connected counters when the input pulse counter counts any number, and an output selection circuit for receiving the selection signal and outputting a corresponding counter value.

A fourth aspect of the present invention is an electronic apparatus provided with a display device, wherein the display device includes at least a display portion having pixels arranged in a matrix, a drive circuit for driving the display portion, and a power supply circuit for boosting up a predetermined voltage and generating a drive voltage inside the substrate based on the output of the oscillation circuit including low temperature polysilicon thin film transistors formed on an insulation substrate; the oscillation circuit has a pulse generation portion including an oscillator for generating pulse signals having a frequency variation and a frequency variation correction portion for outputting output rectangular waves of the pulse generation portion suppressed to a predetermined frequency range, wherein the frequency variation correction portion includes an input pulse counter having n number of counters cascade connected and counting numbers of high level and low level periods of rectangular waves input from the pulse generation portion in a comparison input period, a counter value comparison circuit for generating a selection signal for selecting a last output from an any counter among the cascade connected counters when the input pulse counter counts any number, and an output selection circuit for receiving the selection signal and outputting a corresponding counter value.

### EFFECT OF THE INVENTION

According to the present invention, it becomes possible to suppress the variation of output frequency of an oscillator having a frequency variation within a certain constant guaranteed range.
Further, an independent circuit block not depending upon the voltage and frequency of an interface can be configured and controlled, therefore realization of an integral circuit type liquid crystal display device compatible with the low voltage/high frequency of the interface is possible.
Further, there are the advantages that no adjustment of the oscillation frequency of the oscillator and a greater reduction of the number of parts can be achieved and the yield can be improved along with stabilization of the output frequency.

### BRIEF DESCRIPTION OF THE DRAWINGS

[FIG. 1] FIG. 1 is a diagram showing the schematic configuration of a general integral drive circuit type display device.
[FIG. 2] FIG. 2 is a block diagram showing an example of the configuration of a horizontal drive circuit of FIG. 1 for separately driving odd number lines and even number lines.
[FIG. 3] FIG. 3 is a diagram showing a layout configuration of an integral drive circuit type display device according to an embodiment of the present invention.
[FIG. 4] FIG. 4 is a system block diagram showing circuit functions of an integral drive circuit type display device according to an embodiment of the present invention.
[FIG. 5] FIG. 5 is a circuit diagram showing an example of the configuration of an effective display portion of a liquid crystal display device.
[FIG. 6] FIG. 6 is a block diagram showing an example of the basic configuration of first and second horizontal drive circuits of the present embodiment.
[FIG. 7] FIG. 7 is a block diagram showing the configuration of a power supply circuit using low temperature polysilicon TFTs according to the present embodiment.
[FIG. 8] FIG. 8 is a diagram showing an example of the configuration of a ring oscillator.
[FIG. 9] FIG. 9 is a block diagram showing an example of the configuration of a frequency variation correction portion in a power supply circuit according to the present embodiment.
[FIG. 10] FIG. 10 is a circuit diagram showing a more concrete example of the configuration of the frequency variation correction portion of FIG. 9.
[FIG. 11] FIG. 11 is a timing chart showing the operation of the frequency variation correction portion of FIG. 10 and shows a case where a horizontal synchronization signal Hsync is a high level and a reset signal Rst is a high level. [FIG. 12] FIG. 12 is a timing chart showing the operation of the frequency variation correction portion of FIG. 10 and shows a case where the horizontal synchronization signal Hsync includes a timing of switching from the high level to low level and where the reset signal Rst includes the timing of switching from the high level to low level.
[FIG. 13] FIG. 13 is a diagram showing the frequency characteristics shown by a system having a frequency of the horizontal synchronization signal Hsync of 20 kHz and a length of a low period of 10 µs and changing the frequency of an input rectangular wave.
[FIG. 14] FIG. 14 is a view of the appearance schematically showing the configuration of a mobile phone constituting a portable terminal according to an embodiment of the present invention.

### DESCRIPTION OF NOTATIONS

10... liquid crystal display device, 11... glass substrate, 12... effective display portion, 13... horizontal drive circuit, 13U... first horizontal drive circuit, 13D... second horizontal drive circuit, 135MPL... sampling and latch circuit group, 131... first sampling and latch circuit, 132... second sampling and latch circuit, 133... third sampling and latch circuit, 134... first latch circuit, 135... second latch circuit, 136... third latch circuit, 137... first latch series, 138... second latch series, 13OSEL... latch output selection switch, 13DAC... digital-to-analog conversion circuit, 13ABUD... analog buffer, 13LSEL... line selector, 14... vertical drive circuit, 15... data processing circuit, 16... power supply circuit, 161... boost use pulse generation portion, 162... frequency variation correction portion, 1621... input pulse counter, 1622... counter value comparison logic circuit (or frequency correction logic circuit), 1623... output selection switch, 163... boosting circuit, 17... interface circuit, and 18... timing generator.

### BEST MODE FOR CARRYING OUT THE INVENTION

Below, a detailed explanation will be given of an embodiment of the present invention with reference to the drawings.

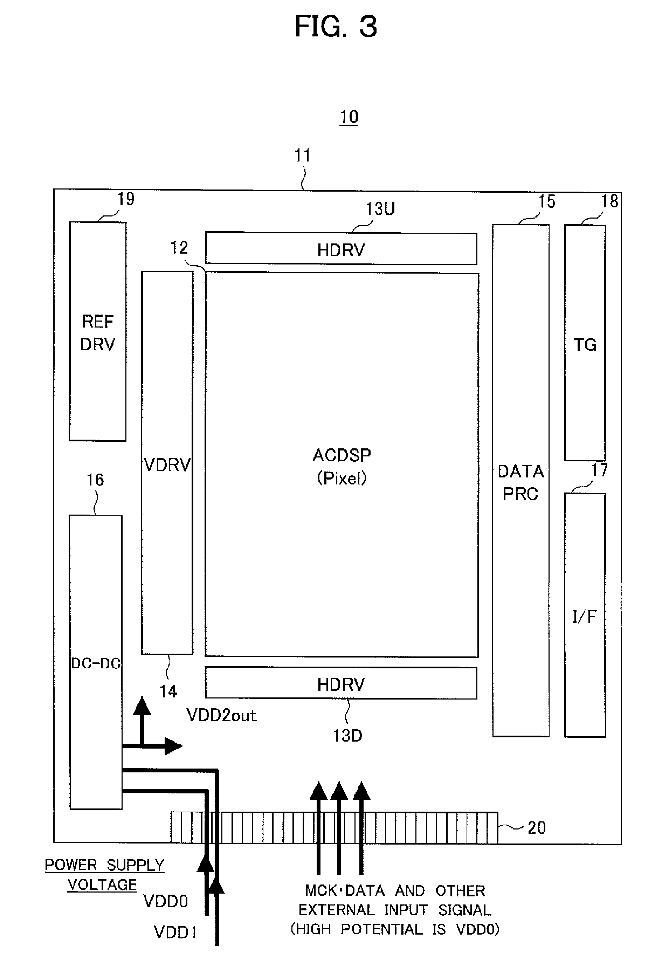

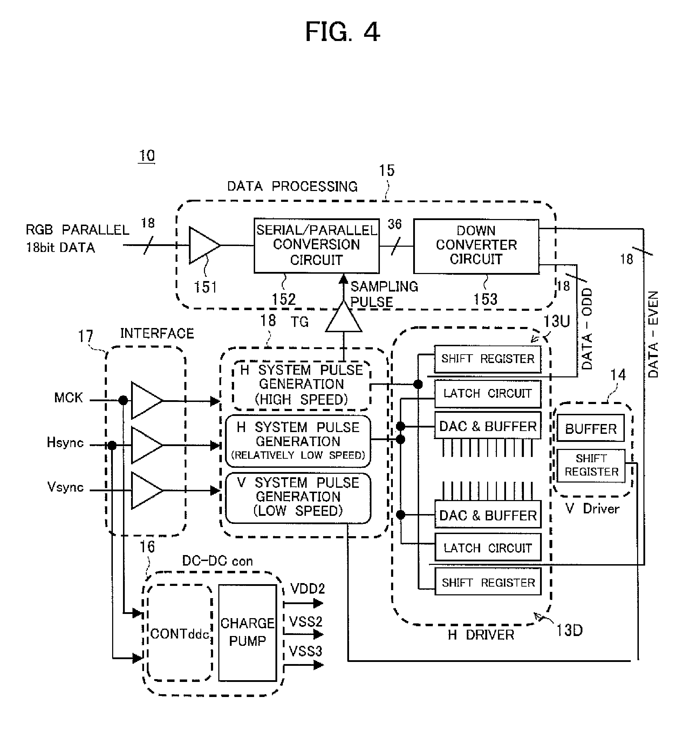

FIG. 3 and FIG. 4 are views of the schematic configuration showing an example of the configuration of an integral drive circuit type display device according to an embodiment of the present invention. FIG. 3 is a diagram showing a layout configuration of the integral drive circuit type display device according to the present embodiment, and FIG. 4 is a system block diagram showing circuit functions of the integral drive circuit type display device according to the present embodiment.
Here, for example, an explanation will be given taking as an example a case where the present embodiment is applied to an active matrix type liquid crystal display device using liquid crystal cells as electro-optical elements of pixels.

This liquid crystal display device 10, as shown in FIG. 3, is comprised of a transparent insulation substrate, for example, a glass substrate 11 on which an effective display portion (ACDSP) 12 having a plurality of pixels including liquid crystal cells arranged in a matrix, a pair of first and second horizontal drive circuits (H drivers, HDRV) 13U and 13D arranged above and below the effective display portion 12 in FIG. 3, a vertical drive circuit (V driver, VDRV) 14 arranged in a side portion of the effective display portion 2 in FIG. 1, a data processing circuit (DATAPRC) 15, a power supply circuit (DC-DC) 16 formed by a DC-DC converter, an interface circuit (I/F) 17, a timing generator (TG) 18, a reference voltage drive circuit (REFDRV) 19 for supplying a plurality of drive reference voltages to the horizontal drive circuits 13U and 13D etc., and so on are integrated.
Further, at an edge in the vicinity of the arrangement position of the second horizontal drive circuit 13D of the glass substrate 11, an input pad 20 for data etc. is formed.

The glass substrate 11 is constituted by a first substrate on which a plurality of pixel circuits including active elements (for example transistors) are formed arranged in a matrix and a second substrate arranged so as to face this first substrate with a predetermined clearance. Then, a liquid crystal is sealed between these first and second substrates.
A circuit group formed on the insulation substrate is formed by the low temperature polysilicon TFT process. Namely, in this integral drive circuit type display device 10, the horizontal drive system and vertical drive system are arranged at the periphery (frame) of the effective display portion 12. These drive systems are integrally formed on the same substrate together with the pixel area by using polysilicon TFTs.

In the integral drive circuit type display device 10 of the present embodiment, two horizontal drive circuits 13U and 13D are arranged on the two sides (above and below in FIG. 3) of the effective pixel portion 12. This arrangement is made in order to drive the data lines divided into odd number lines and even number lines.
In the two horizontal drive circuits 13U and 13D, three digital data are stored in sampling and latch circuits, processing for conversion to analog data is carried out three times by a common digital-to-analog conversion circuit in one horizontal period (H), and three analog data are selected in a time division manner within the horizontal period and output to the data lines (signal lines), whereby an RGB selector scheme is employed.
In the present embodiment, among the three digital image data R, G, and B, the explanation will be given by defining the digital R data as the first digital data, defining the digital B data as the second digital data, and defining the digital G data as the third digital data.

Below, an explanation will be given of the configurations and functions of components of the liquid crystal display device 10 of the present embodiment in sequence.

In the effective display portion 12, a plurality of pixels including liquid crystal cells are arranged in a matrix state.
Further, the effective display portion 12 is provided with data lines and vertical scan lines driven by the horizontal drive circuits 13U and 13D and vertical drive circuit 14 arranged in a matrix.

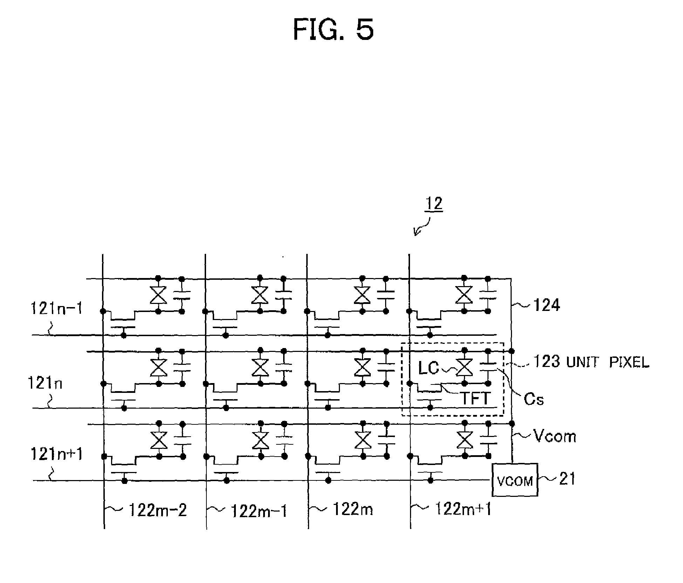

FIG. 5 is a diagram showing an example of the concrete configuration of the effective display portion 12.
Here, for simplification of the drawing, a case of arrangement of the pixels in three rows (n-1-th row to n+1-th row) and four columns (m-2-th column to m+1-th column) is taken as an example.
In FIG. 4, the display portion 12 is provided with vertical scan lines... , 121n-1, 121n, 121n+1,... , and data lines... , 122m-2, 122m-1, 122m, 122m+1,... laid in a matrix and unit pixels 123 arranged at intersecting portions of the same.

The unit pixel 123 is configured having a thin film transistor TFT as a pixel transistor, a liquid crystal cell LC, and a storage capacitor Cs. Here, the liquid crystal cell LC means a capacity generated between a pixel electrode (one electrode) formed by the thin film transistor TFT and a counter electrode (other electrode) formed facing this.

Thin film transistors TFT are connected at their gate electrodes to vertical scan lines... , 121n-1, 121n, 121n+1,... and connected at their source electrodes to data lines... , 122m-2, 122m-1, 122m, 122m+1,....
The liquid crystal cell LC is connected at its pixel electrode to a drain electrode of the thin film transistor TFT and connected at its counter electrode to a common line 124. The storage capacitor Cs is connected between the drain electrode of the thin film transistor TFT and the common line 124.
The common line 124 is given a predetermined AC voltage as a common voltage Vcom by a VCOM circuit 21 integrally formed with the drive circuit etc. on the glass substrate 11.

Each of the first side ends of the vertical scan lines... , 121n-1, 121n, 121n+1,... is connected to each output end of the corresponding row of the vertical drive circuit 14 shown in FIG. 3.
The vertical drive circuit 14 is configured so as to include for example a shift register and performs a vertical scan by sequentially generating vertical selection pulses in synchronization with vertical transfer clocks VCK (not shown) and giving these to vertical scan lines... , 121-1, 121n, 121n+1,... .

Further, in the display portion 12, for example, each of first side ends of the data lines... , 122m-1, 122m+1,..., is connected to each output end of the corresponding column of the first horizontal drive circuit 13U shown in FIG. 1, and each of the other side ends is connected to each output end of the corresponding column of the second horizontal drive circuit 13D shown in FIG. 3.

The first horizontal drive circuit 13U stores three digital data of R data, B data, and G data in sampling and latch circuits, performs the processing for conversion to analog data three times in one horizontal period (H), selects three data in a time division manner within the horizontal period, and outputs the same to corresponding data lines.
The first horizontal drive circuit 13U, along with employment of this RGB selector scheme, transfers the R data and B data latched in the first and second sampling and latch circuits to the first latch circuit and further to the second latch circuit in a time division manner, transfers the G data latched in the third sampling and latch circuit during this time divisional transfer processing of the R data and B data to the latch circuits to the third latch circuit, selectively outputs the R, B, and G data latched in the second latch circuit and third latch circuit in one horizontal period and converts the same to analog data, and selects three analog data in a time division manner in the horizontal period and outputs the same to corresponding data lines.
Namely, in order to realize the RGB selector system, by configuring the horizontal drive circuit 13U of the present embodiment so that a first latch series for two digital data R and B and a second latch series for one digital G data are arranged in parallel and so that a digital-to-analog conversion circuit (DAC), an analog buffer, and a line selector after the selector are shared, a narrowing of the frame and lowering of the power consumption are achieved.
The second horizontal drive circuit 13D basically has the same configuration as that of the first horizontal drive circuit 13U.

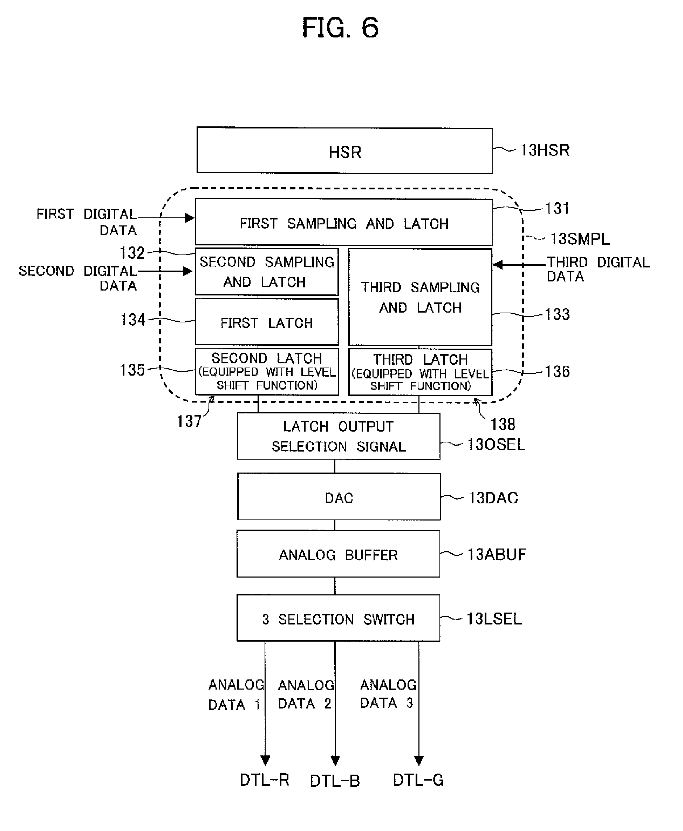

FIG. 6 is a block diagram showing an example of the basic configuration of the first horizontal drive circuit 13U and the second horizontal drive circuit 13D of the present embodiment, Below, these will be explained as the "horizontal drive circuit 13".
Note that, this horizontal drive circuit shows the fundamental configuration corresponding to three digital data. In actuality, a plurality of the same configurations are arranged in parallel.

The horizontal drive circuit 13, as shown in FIG. 6, has a shift register (HSR) group 13HSR, a sampling and latch circuit group 13SMPL, a latch output selection switch 130SEL, a digital-to-analog conversion circuit 13DAC, an analog buffer 13ABUF, and a line selector 13LSEL.

The shift register group 13HSR has a plurality of shift registers (HSR) for sequentially outputting shift pulses (sampling pulses) to the sampling and latch circuit group 13SMPL from transfer stages corresponding to columns in synchronization with the horizontal transfer clocks (HCK) (not shown).

The sampling and latch circuit group 13SMPL has a first sampling and latch circuit 131 for sequentially sampling and latching the R data as the first digital data, a second sampling and latch circuit 132 for sequentially sampling and latching the B data as the second digital data and latching the R data latched in the first sampling and latch circuit 131 at a predetermined timing, a third sampling and latch circuit 133 for sequentially sampling and latching the G data as the third digital data, a first latch circuit 134 for serially transferring the digital R or B data latched in the second sampling and latch circuit 132, a second latch circuit 135 having a level shift function of converting the digital R or B data latched in the first latch circuit 134 to a higher voltage amplitude and latching the same, and a third latch circuit 136 having a level shift function of converting the digital G data latched in the third sampling and latch circuit 133 to a higher voltage amplitude and latching the same.
In the sampling and latch circuit group 13SMPL having such a configuration, the first latch series 137 is formed by the first sampling and latch circuit 131, second sampling and latch circuit 132, first latch circuit 134, and second latch circuit 135, and the second latch series 138 is formed by the third sampling and latch circuit 133 and third latch circuit 136.

In the present embodiment, data to be input from the data processing circuit 15 to the horizontal drive circuits 13U and 13D are supplied at levels of 0 to 3V (2.9V).
Then, these are raised in levels to for example -2.3V to 4.8V by the level shift function of the second and third latch circuits 135 and 136 as output stages of the sampling and latch circuit group 13SMPL.

The latch output selection switch 13OSEL selectively switches outputs of the sampling and latch circuit group 13SMPL and outputs the same to the digital-to-analog conversion circuit 13DAC.
The digital-to-analog conversion circuit 13DAC performs digital/analog conversion three times in one horizontal period. Namely, the digital-to-analog conversion circuit 13DAC converts three digital R, B, and G data to analog data in one horizontal period.
The analog buffer 13ABUF buffers the R, B, and G data converted to analog signals at the digital-to-analog conversion circuit 13DAC and outputs the same to the line selector 13LSEL.
The line selector 13LSEL selects three analog R, B, and G data in one horizontal period and outputs the same to corresponding data lines DTL-R, DTL-B, and DTL-G.

Here, an explanation will be given of the operation in the horizontal drive circuit 13.

In the horizontal drive circuit 13, when sampling continuous image data, they are stored in the first, second, and third sampling and latch circuits 131, 132, and 133.
When the storage of all data of one line in a horizontal direction into the first, second, and third sampling and latch circuits 131 to 133 is completed, the data in the second sampling and latch circuit 132 is transferred to the first latch circuit 134 in a horizontal direction blanking period and immediately transferred to the second latch circuit 135 and stored.
Next, the data in the first sampling and latch circuit 131 is transferred to the second sampling and latch 132 and immediately transferred to the first latch circuit 134 and stored. Further, the data in the third sampling and latch circuit 133 is transferred to the third latch circuit 136 in the same period.
Then, the data of the next horizontal direction line is stored into the first, second, and third sampling and latch circuits 131, 132, and 133.
During a term where the data of the next horizontal direction line is stored, the data stored in the second latch circuit 135 and third latch circuit 136 are output to the digital-to-analog conversion circuit 13DAC by the switching of the latch output selection switch 13OSEL.
After that, the data stored in the first latch circuit 134 is transferred to the second latch circuit 135 and stored. That data is output to the digital-to-analog conversion circuit 13DAC by the switching of the latch output selection switch 13OSEL.
By this sampling and latch scheme, three digital data are output to the digital-to-analog conversion circuit 13DAC, therefore it becomes possible to accomplish higher precision/narrower framing,
Further, since there is no accompanying transfer work while storing one horizontal direction line of data and since writing in a sequence of B (Blue) → G (Green) → R (Red) in the case of RGB selector drive is sufficient from the viewpoint of the VT characteristics of liquid crystals, the third digital data may be made data of the color exerting the biggest influence upon the human eye, that is, the G data, whereby this system becomes strong against fluctuations in the image quality.

The data processing circuit 15 has a level shifter 151 for shifting levels of parallel digital R, G, and B data input from the outside from the 0 to 3V (2.9V) system to a 6V system, a serial/parallel conversion circuit 152 for converting the R, G, and B data from serial data to parallel data in order to perform phase adjustment and lowering of the frequency, and a down converter 153 for down shifting the parallel data from the 6V system to the 0 to 3V (2.9V) system and outputting odd number data (odd data) to the horizontal drive circuit 13U and outputting even number data (even data) to the horizontal drive circuit 13D.

The power supply circuit 16 includes a DC-DC converter, is supplied with for example a liquid crystal voltage VDD1 (for example 2.9V) from the outside, uses a built-in oscillation circuit to boost up this voltage to an internal panel voltage VDD2 (for example 5.8V) of the double 6V system in synchronization with a master clock MCK supplied from the interface circuit 17 and the horizontal synchronization signal Hsync or based on a corrected clock obtained by correcting a clock having a low (slow) frequency and having a variation in oscillation frequency by a predetermined correction system, and supplies this to circuits inside the panel.
Further, the power supply circuit 16 generates VSS2 (for example -1.9V) and VSS3 (for example -3.8V) as negative voltages as internal panel voltages and supplies these to predetermined circuits (interface circuit etc.) inside the panel.

Here, an explanation will be given of the configuration of the power supply circuit 16 for using a built-in oscillation circuit to boost up the voltage to the internal panel voltage VDD2 (for example 5.8V) of the double 6V system based on a corrected clock obtained by correcting a clock having a low (slow) frequency and having a variation in oscillation frequency by a predetermined correction system and the horizontal synchronization signal Hsync as the characteristic configuration of the present embodiment and supplying the same to circuits inside the panel.

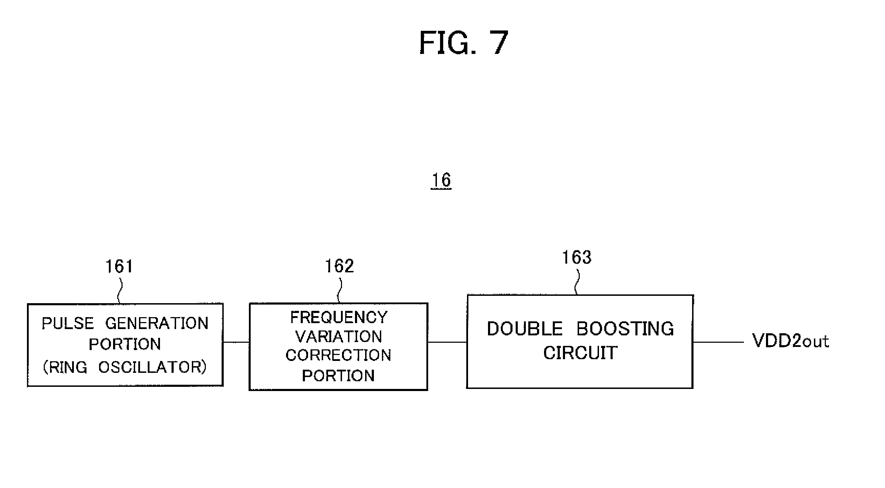

FIG. 7 is a block diagram showing the configuration of a power supply circuit using low temperature polysilicon TFTs according to the present embodiment.
This power supply circuit 16 is configured by a boost use pulse generation portion 161, frequency variation correction portion 162 formed by a frequency division correction system, and double boosting circuit 163.
Further, the oscillation circuit is formed by the boost use pulse generation portion 161 and frequency variation correction portion 162.

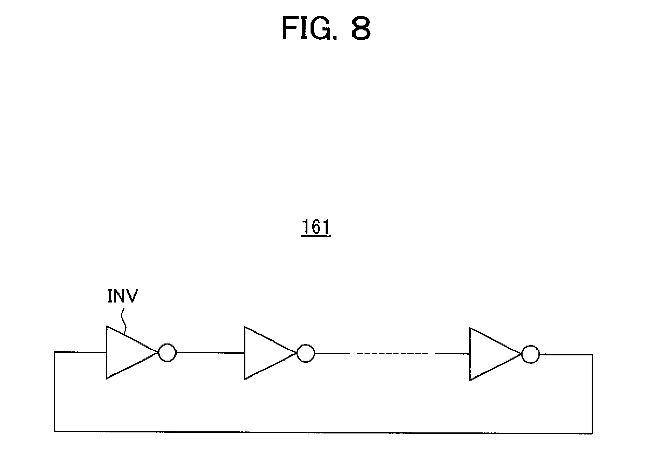

The pulse generation portion 161 is formed by for example a ring oscillator (oscillator) as shown in FIG. 8 which is obtained by connecting an odd number of inverters INV in a ring state and generates boost use pulses.
An oscillator configured by the transistors formed by the low temperature polysilicon process varies in transistor characteristics in accordance with transistor conditions, temperature, humidity, and other various conditions. As a result, the oscillation frequency largely varies.
Namely, the pulse generation portion 161 is formed in an oscillation circuit outputting rectangular wave signals having a frequency variation.

The frequency variation correction portion 162 suppresses output rectangular waves of the pulse generation portion 161 to within a certain frequency range in synchronization with for example the horizontal synchronization signal Hsync or vertical synchronization signal Vsync and outputs the result to the boosting circuit 163.
The frequency variation correction portion 162 of the present embodiment is characterized in that it does not require the input of a reference frequency for a phase comparison when correcting the variation of output frequencies.
Namely, the frequency variation correction portion 162 is a circuit for suppressing frequency variation since the oscillation frequency of the oscillation circuit greatly varies according to the process conditions. It has the configuration as explained below and is formed so as to adjust the number of frequency dividers to match with the extent of variation of the oscillator itself.

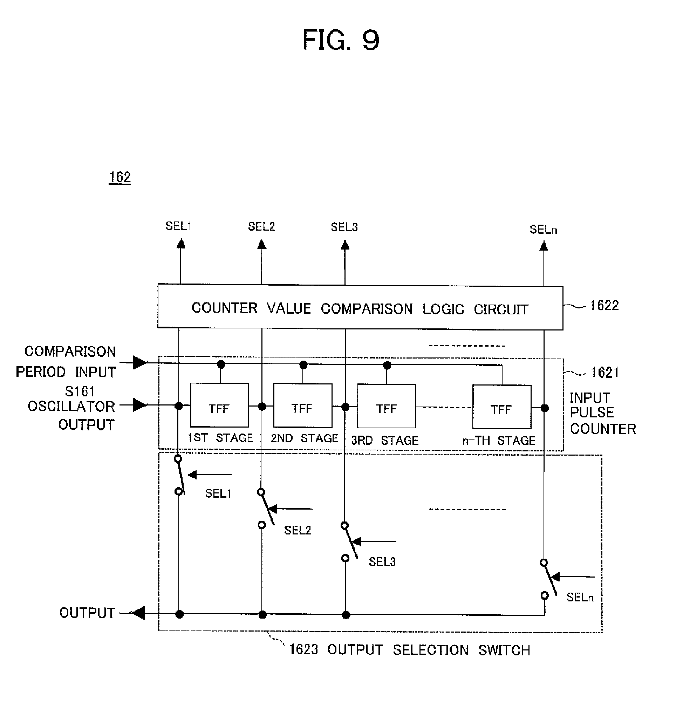

FIG. 9 is a block diagram showing an example of the configuration of the frequency variation correction portion in the power supply circuit according to the present embodiment.

The frequency variation correction portion 162 of FIG. 9 is configured by an input pulse counter 1621 of oscillation output pulses of the pulse generation portion 161, a counter value comparison logic circuit (or frequency correction logic circuit) 1622, and an output selection switch 1623.

The input pulse counter 1621 is a counter configured by a cascade connection of n number of 2-bit counters made of for example T-type flip-flop TFFs and counting numbers of high level and low level periods of rectangular waves input in the comparison input period.The input pulse counter 1621 starts the count operation by the release of reset and ends the variation correction when reset next. By selecting any number of times of frequency division in accordance with the count number (input frequency) in this period, output rectangular waves can be contained within any frequency range.
For frequency-divided outputs of the input, outputs of the input pulse counter are utilized.

When the input pulse counter 1621 counts any number, the counter value comparison logic circuit (frequency correction logic circuit) 1622 generates signals SEL1 to SELn for selecting the last output from any counter among the cascade-connected counters and outputs the same to the output selection switch 1623. The results of this output selection (frequency correction results with respect to input rectangular waves) are held until the logic reset.

The output selection switch 1623 receives output selection signals SEL1 to SELn and outputs corresponding counter values. According to the combination of logics in the counter value comparison logic circuit 1622, the determination of the lowest/highest value of output frequencies and adjustment of the ratio of these can be carried out.

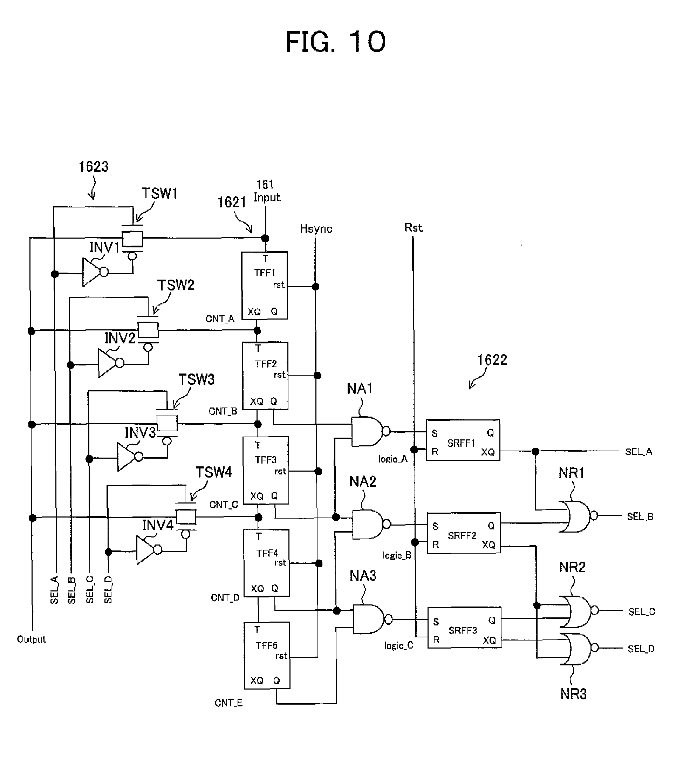

FIG. 10 is a circuit diagram showing a more concrete example of the configuration of the frequency variation correction portion 162 of FIG. 9.

In this example, the input pulse counter 1621 is formed by five cascade-connected T-type flip-flop TFFs. Horizontal synchronization signals Hsync are supplied as comparison period input signals to reset terminals rst of five cascade-connected T-type flip-flops TFF1 to TFF5.

The counter value comparison logic circuit (frequency correction logic circuit) 1622 is formed by three SR type flip-flops SRFF1 to SRFF3, three NAND gates NA1 to NA3, and three NOR gates NR1 to NR3.
An S-terminal of the SR type flip-flop SRFF1 is connected to an output terminal of the NAND gate NA1, an output selection signal SELA is output from an output terminal XQ, and the terminal XQ is connected to one input terminal of the NOR gate NR1.
The S-terminal of the SR type flip-flop SRFF2 is connected to the output terminal of the NAND gate NA2, the output terminal Q is connected to the other input terminal of the NOR gate NR1, and the output terminal XQ is connected to first side input terminals of the NOR gates NR2 and NR3. Then, an output selection signal SELB is output from the output terminal of the NOR gate NR1.
The S-terminal of the SR type flip-flop SRFF3 is connected to the output terminal of the NAND gate NA3, the output terminal Q is connected to the other input terminal of the NOR gate NR2, and the output terminal XQ is connected to the other input terminal of the NOR gate NR3. Then, an output selection signal SELC is output from the output terminal of the NOR gate NR2, and an output selection signal SELD is output from the output terminal of the NOR gate NR3.
The reset terminals rst of three SR type flip-flops SRFF1 to SRFF3 are connected to a supply line of a reset pulse Rst which is sufficiently longer than the horizontal synchronization signal Hsync.
One input terminal of the NAND stage NA1 is connected to the output terminal Q of the T-type flip-flop TFF2, while the other input terminal is connected to the output terminal Q of the T-type flip-flop TFF3.
One input terminal of the NAND stage NA2 is connected to the output terminal Q of the T-type flip-flop TFF3, while the other input terminal is connected to the output terminal Q of the T-type flip-flop TFF4.
One input terminal of the NAND stage NA3 is connected to the output terminal Q of the T-type flip-flop TFF4, while the other input terminal is connected to the output terminal Q of the T-type flip-flop TFF5.

The output selection switch 1623 is formed by four CMOS switches TSW1 to TSW4 and inverters INV1 to INV4.

The input pulse counter 1621 is reset by a pulse of the horizontal synchronization signal (Hsync), while the counter value comparison logic circuit (frequency correction logic circuit) 1622 is reset by a pulse (Rst) sufficiently longer than the horizontal synchronization signal Hsync.
Further, the XQ outputs of the T-type flip-flops TFF1 to TFF5 (counters) are defined as CNT_A to CNT_E.

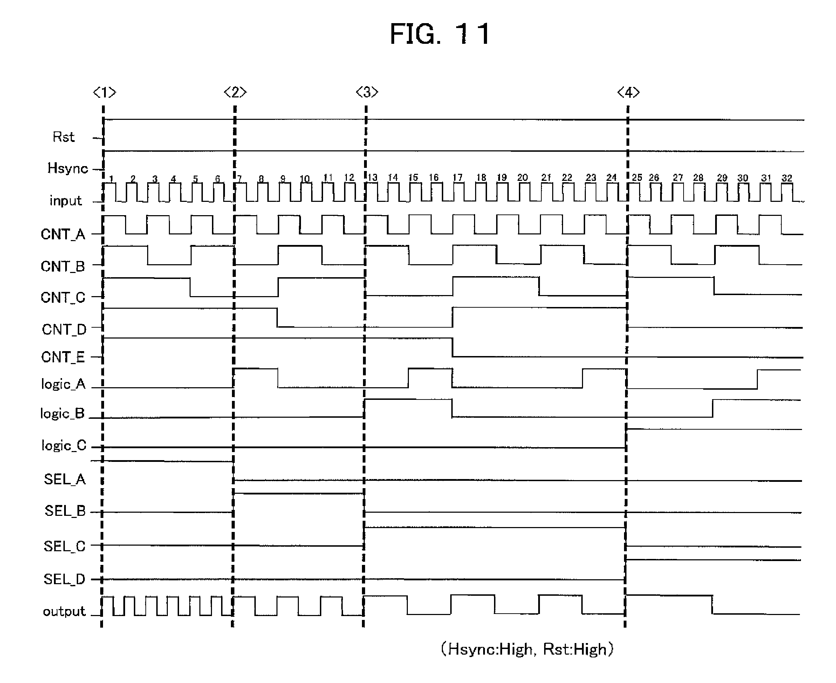

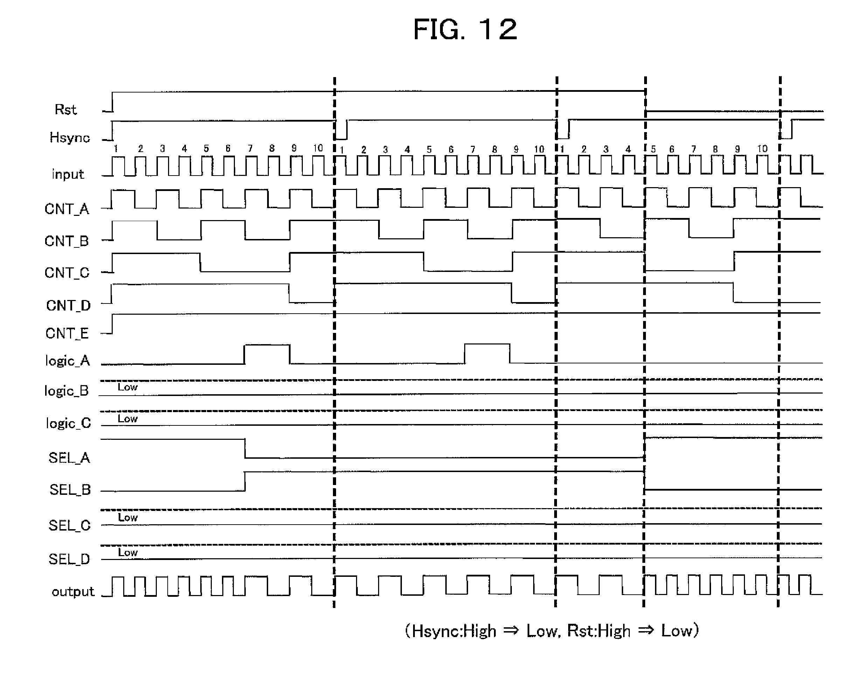

FIG. 11 and FIG. 12 are timing charts showing operations of the frequency variation correction portion of FIG. 10. FIG. 11 shows a case where the horizontal synchronization signal Hsync is at the high level and the reset signal Rst is at the high level, and FIG. 12 shows a case where the horizontal synchronization signal Hsync includes a timing of switching from the high level to the low level and the reset signal Rst includes a timing of switching from the high level to the low level.

Below, an explanation will be given of the operation of the frequency variation correction portion of FIG. 10 with reference to FIG. 11.

Here, assume that the horizontal synchronization signal Hsync becomes the high level and the reset of the counter is released at a timing <1> of FIG. 11. During the period until the horizontal synchronization signal Hsync becomes the low level next, according to the count number (input frequencies), the selection operations of the frequency division numbers are classified into the cases as follows.

1. All of logic_A to logic_C are low when the number of the high periods of the input rectangular waves is less than seven. The output selection signal SEL_A is output at a high level at this time. Due to this, a pulse signal S161 input by the pulse generation portion 161 is output as it is (FIG. 11<1>-<2>).

2. The logic_A is high when the number of high periods of input rectangular waves is seven to less than 13. The output selection signal SEL_B is output at a high level at this time. Due to this, CNT_A as the 2-frequency division of the input is selected as the output (FIG. 11<2>-<3>).

3. The logic_B is high when the number of high periods of input rectangular waves is 13 to less than 25 times. The output selection signal SEL_C is output at a high level at this time. Due to this, CNT_B as the 4-frequency division of the input is selected as the output (FIG. 11<3>-<4>).

4. The logic_C is high when the number of high periods of input rectangular waves is 25 or more. The SEL_D is output at a high level at this time. Due to this, CNT_C as the 8-frequency division of the input is selected as the output (right from FIG. 11<4>).

Next, when the horizontal synchronization signal Hsync becomes low, the counters (TFF1 to TFF5) are reset, but the high or low levels of the frequency division selection signals SEL_A to SEL_D are latched in the SR type flip-flop SRFF1, so the results of frequency division correction are maintained during the term until the reset signals Rst become low.
When the reset signals Rst become low, the selection signals SEL_B to SEL_D become low and the selection signal SEL_A becomes high, so variation is not corrected, and the input is output as it is.

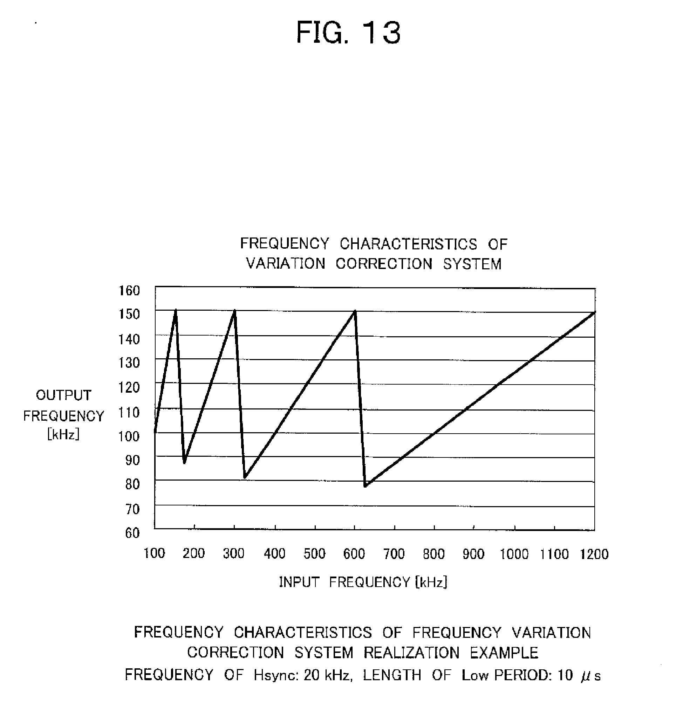

As an example, the operation of the system when the horizontal synchronization signal Hsync becomes low immediately after the high period of the input is counted 10 times is shown in the timing chart of FIG. 12.
Here, the frequency characteristics shown by the system when the frequency of the input rectangular wave is changed when the frequency of the horizontal synchronization signal Hsync is 20 kHz and the length of the low period is 10 µs are shown in FIG. 13.
As seen from FIG. 13, assuming that an oscillator varying in its oscillation frequency from 100 kHz to 1.2 MHz (the highest value is 12 times the lowest value) is connected to the frequency correction system, the output frequency becomes 78.1 kHz at the lowest and becomes 150 kHz at the highest, so the difference between the lowest value and highest value is suppressed to 1.92 times.

The interface circuit 17 shifts the levels of the master clock MCK supplied from the outside, horizontal synchronization signal Hsync, and vertical synchronization signal Vsync up to the logic level inside the panel (for example VDD2 level), supplies the master clock MCK, horizontal synchronization signal Hsync, and vertical synchronization signal Vsync after the level shift to the timing generator 18, and supplies the horizontal synchronization signal Hsync to the power supply circuit 16.
When the power supply circuit 16 is configured so as to perform the boosting based on a corrected clock obtained by correcting a clock of the built-in oscillation circuit without using a master clock, the interface circuit 17 can be configured so as not to supply the master clock MCK to the power supply circuit 16. Alternatively, it is also possible to configure these so that the supply line of the master clock MCK from the interface circuit 17 to the power supply circuit 16 is kept as it is, but the master clock MCK is not used for boosting at the power supply circuit 16 side.

The timing generator 18, in synchronization with the master clock MCK supplied by the interface circuit 17, horizontal synchronization signal Hsync, and vertical synchronization signal Vsync, generates a horizontal start pulse HST and horizontal clock pulse HCK (HCKX) which are used as clocks of the horizontal drive circuits 13U and 13D and a vertical start pulse VST and vertical clock VCK (VCKX) which are used as clocks of the vertical drive circuit 14, supplies the horizontal start pulse HST and horizontal clock pulse HCK (HCKX) to the horizontal drive circuits 13U and 13D, and supplies the vertical start pulse VST and vertical clock VCK (VCKX) to the vertical drive circuit 14.

Next, an explanation will be given of the operation according to the above configuration.

The voltages VDD0 and VDD1 supplied from the outside are input to the power supply circuit 16.
In the power supply circuit 16, after the voltage VDD1 is boosted up to the drive voltage VDD2 inside the panel, the external input signal is level shifted up to VDD2, whereby all circuits become able to be driven.
When the power supply circuit 16 turns on the supply of power, rectangular wave signals S161 having a frequency variation are output from the pulse generation portion 161 to the frequency variation correction portion 162.
In the frequency variation correction portion 162, in synchronization with for example the horizontal synchronization signal Hsync, the output rectangular waves of the pulse generation portion 161 are suppressed to within a certain frequency range and output to the boosting circuit 163. In the boosting circuit 163, for example the liquid crystal voltage VDD1 (for example 2.9V) is boosted up to the internal panel voltage VDD2 (for example 5.8V) of the double 6V system based on a corrected clock obtained by correcting a clock having a variation in its oscillation frequency by a predetermined correction system and horizontal synchronization Hsync and supplied to circuits inside the panel.

Then, parallel digital data input from the outside are subjected to parallel conversion in order to adjust the phases and lower the frequencies by the data processing circuit 15 on the glass substrate 11. The R data, B data, and G data are output to the first and second horizontal drive circuits 13U and 13D. In the first and second horizontal drive circuits 13U and 13D, the digital G data input from the data processing circuit 15 are sequentially sampled and held for 1H at the third sampling and latch circuit 133. After that, they are transferred to the third latch circuit 136 for the horizontal blanking period.
Parallel to this, the R data and B data are separately sampled for 1H and held in the first and second sampling and latch circuits 131 and 132 and transferred to first latch circuit 134 for the next horizontal blanking period.
When all data of one horizontal direction line finishes being stored in the first, second, and third sampling and latch circuits 131 to 133, the data in the second sampling and latch circuit 132 is transferred to the first latch circuit 134 in the horizontal directional blanking period and immediately transferred to the second latch circuit 135 and stored.
Next, the data in the first sampling and latch circuit 131 is transferred to the second sampling and latch 132 and immediately transferred to the first latch circuit 134 and stored. Further, the data in the third sampling and latch circuit 133 is transferred to the third latch circuit 136 in the same period.
Then, the data of the next horizontal direction line are stored into the first, second, and third sampling and latch circuits 131, 132, and 133.
During the period where the data of the next horizontal directional line are stored, data stored in the second latch circuit 135 and third latch circuit 136 are output to the digital-to-analog conversion circuit 13DAC by the switching of the latch output selection switch 13OSEL.
After that, the data stored in the first latch circuit 134 is transferred to the second latch circuit 135 and stored. That data is output to the digital-to-analog conversion circuit 13DAC by the switching of the latch output selection switch 13OSEL.
The R, B, and G data converted to analog data at the digital-to-analog conversion circuit 13DAC in the next 1H period are held in the analog buffer 13ABUF, and the analog R, B, and G data are selectively output to the corresponding data lines in forms where the 1H period is divided into three.
Note that even when the order of processing of G, R, and B is switched, this can be accomplished.

As explained above, according to the present embodiment, provision is made of a pulse generation portion 161 formed by an oscillator for outputting rectangular wave signals having a frequency variation and a frequency variation correction portion 162 for suppressing output rectangular waves of the pulse generation portion 161 within a certain frequency range and outputting the same to the boosting circuit 163, therefore the following effects can be obtained.
Namely, it becomes possible to suppress the variation of output frequencies of the oscillator having a frequency variation within a certain constant guaranteed range.
Further, an independent circuit block not depending upon the voltage and frequency of the interface can be configured and controlled, therefore the realization of an integral circuit type liquid crystal display device corresponding to the low voltage/high frequency of the interface is possible.
Furthermore, there are the advantages that elimination of adjustment of the oscillation frequency of the oscillator and a greater reduction of the number of parts can be achieved, and the yield can be improved along with the stabilization of output frequencies.

Further, according to the present embodiment, provision is made of a first latch series 137 formed by cascade-connecting the sampling and latch circuits 131 and 132 for the first digital data (R) and second digital data (B), first latch circuit 134, and second latch circuit 135 and serially transferring data and a second latch series 138 formed by cascade-connecting the sampling and latch circuit 133 and third latch circuit 136 for the third digital data, and provision is further made of a common digital-to-analog (DA) conversion circuit 13DAC, analog buffer circuit 13ABUF, and line selector 13LSEL for selectively outputting three analog data (R, B, G) to corresponding data lines in one horizontal period (H), therefore the following effects can be obtained.
By employing this configuration, the number of DA conversion circuits/analog buffer circuits which become necessary for the same width of the dot pitch is decreased from the existing system, and it becomes possible to realize narrower framing.
Further, by configuring the data processing circuit from sampling and latch circuits for the first and second digital data and for the third digital data, it becomes possible to realize a higher precision.
Namely, according to the present system, a three-line selector system made higher in fineness and narrower in framing and an integral drive circuit type display device using this can be realized on the insulation substrate.
Further, the number of circuits the horizontal drive circuits can be decreased, therefore a low power consumption three-line selector system and an integral drive circuit type display device using this can be realized.
Further, a three-line selector system operating at a high speed since it outputs data by division into three in one horizontal period, but strong against variation of the image quality and an integral drive circuit type display device using this can be realized.

Note that, in the above embodiment, the explanation was given taking as an example the case where the present invention was applied to an active matrix type liquid crystal display device, but the present invention is not limited to this and can be applied to an EL display device using electroluminescence (EL) elements as electro-optical elements of pixels and other active matrix type display devices in the same way as well.

Furthermore, the active matrix type display device represented by the active matrix type liquid crystal display device according to the present embodiment is used as the display of a personal computer, word processor, or other OA apparatus, and television receiver. Other than these, it is preferred particularly when this device is used as the display portions of mobile phones, PDAs, and other portable terminals being reduced in size of housings and being made more compact.

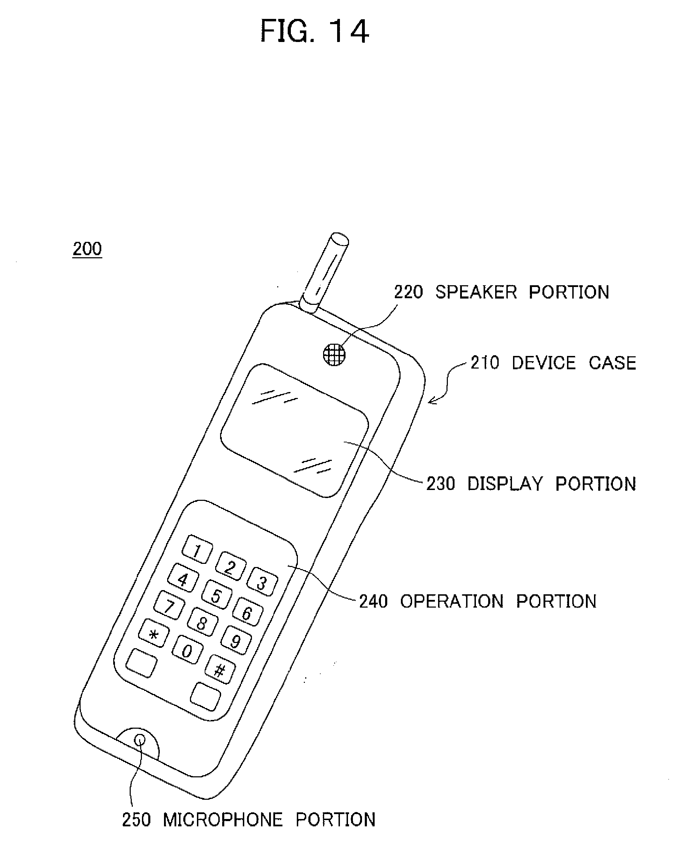

FIG. 14 is a view of the appearance schematically showing the configuration of a portable terminal to which the present invention is applied, for example, a mobile phone.

A mobile phone 200 according to the present example is configured by a speaker portion 220, display portion 230, operation portion 240, and microphone portion 250 sequentially arranged from an upper portion on the front surface of the device case 210.
In a mobile phone having such a configuration, as the display portion 230, use is made of for example a liquid crystal display device. As this liquid crystal display device, use is made of the previously explained active matrix type liquid crystal display device according to the present embodiment.

In this way, in mobile phones and other portable terminals, by using the active matrix type liquid crystal display device according to the above-mentioned embodiment as the display portion 230, it is possible to suppress variation of the output frequency of the oscillator having a frequency variation within a certain constant guaranteed range, and an independent circuit block not depending upon the voltage and frequency of the interface can be configured and controlled. For this reason, realization of an integral circuit type display device corresponding to the low voltage/high frequency of the interface is possible, elimination of adjustment of the oscillation frequency of the oscillator and a great reduction of the number of parts can be achieved, and the yield can be improved along with the stabilization of output frequency.
Further, narrowing of the pitch is possible, narrowing of the frame can be realized, and lower power consumption of the display device can be achieved. Accordingly, a reduction of the power consumption of the terminal becomes possible.

### INDUSTRIAL APPLICABILITY

The oscillation circuit and power supply circuit of the present invention, the display device using the same, and the electronic apparatus can be built in the display panel without causing an increase of the cost and adjustment work is not needed. Therefore, other than the use as displays of personal computers, word processors, and other OA apparatuses, television receivers, etc., they can be applied particularly as display portions of mobile phones, PDAs, and other portable terminals being reduced in size of housings and being made more compact.

## Claims

1. An oscillation circuit including low temperature polysilicon thin film transistors formed on an insulation substrate, comprising
a pulse generation portion including an oscillator for generating pulse signals having a frequency variation and
a frequency variation correction portion for outputting output rectangular waves of the pulse generation portion suppressed to a predetermined frequency range, wherein
the frequency variation correction portion includes
an input pulse counter comprising n number of counters cascade connected and counting numbers of high level and low level periods of rectangular waves input from the pulse generation portion in a comparison input period,
a counter value comparison circuit for generating a selection signal for selecting a last output from an any counter among the cascade connected counters when the input pulse counter counts any number, and
an output selection circuit for receiving the selection signal and outputting a corresponding counter value.

2. An oscillation circuit as set forth in claim 1, wherein the input pulse counter starts a count operation by a release of reset and ends the variation correction at the time of the next reset.

3. An oscillation circuit as set forth in claim 1, wherein frequency correction results with respect to input rectangular waves are held until the reset is applied.

4. An oscillation circuit as set forth in claim 1, wherein, according to a combination of logics in the counter value comparison circuit, determination of the lowest/highest value of the output frequency and ratio adjustment thereof are possible.

5. A power supply circuit for boosting up a predetermined voltage based on an output of an oscillation circuit including low temperature polysilicon thin film transistors formed on an insulation substrate, wherein
the oscillation circuit has
a pulse generation portion including an oscillator for generating pulse signals having a frequency variation and
a frequency variation correction portion for outputting output rectangular waves of the pulse generation portion suppressed to a predetermined frequency range, wherein
the frequency variation correction portion includes
an input pulse counter comprising n number of counters cascade connected and counting numbers of high level and low level periods of rectangular waves input from the pulse generation portion in a comparison input period,
a counter value comparison circuit for generating a selection signal for selecting a last output from an any counter among the cascade connected counters when the input pulse counter counts any number, and
an output selection circuit for receiving the selection signal and outputting a corresponding counter value.

6. A power supply circuit as set forth in claim 5, wherein the input pulse counter starts a count operation by a release of reset and ends the variation correction at the time of the next reset.

7. A power supply circuit as set forth in claim 5, wherein frequency correction results with respect to input rectangular waves are held until the reset is applied.

8. A power supply circuit as set forth in claim 5, wherein, according to a combination of logics in the counter value comparison circuit, determination of the lowest/highest value of the output frequency and ratio adjustment thereof are possible.

9. A display device including at least
a display portion having pixels arranged in a matrix,
a drive circuit for driving the display portion, and
a power supply circuit for boosting up a predetermined voltage and generating a drive voltage inside the substrate based on the output of the oscillation circuit including low temperature polysilicon thin film transistors formed on an insulation substrate, wherein
the oscillation circuit has
a pulse generation portion including an oscillator for generating pulse signals having a frequency variation and
a frequency variation correction portion for outputting output rectangular waves of the pulse generation portion suppressed to a predetermined frequency range, wherein
the frequency variation correction portion includes
an input pulse counter comprising n number of counters cascade connected and counting numbers of high level and low level periods of rectangular waves input from the pulse generation portion in a comparison input period,
a counter value comparison circuit for generating a selection signal for selecting a last output from an any counter among the cascade connected counters when the input pulse counter counts any number, and
an output selection circuit for receiving the selection signal and outputting a corresponding counter value,

10. A display device as set forth in claim 9, wherein the input pulse counter starts a count operation by a release of reset and ends the variation correction at the time of the next reset.

11. A display device as set forth in claim 9, wherein frequency correction results with respect to input rectangular waves are held until the reset is applied.

12. A display device as set forth in claim 9, wherein, according to a combination of logics in the counter value comparison circuit, determination of the lowest/highest value of the output frequency and ratio adjustment thereof are possible.

13. An electronic apparatus having a display device, wherein
the display device includes at least
a display portion having pixels arranged in a matrix,
a drive circuit for driving the display portion, and
a power supply circuit for boosting up a predetermined voltage and generating a drive voltage inside the substrate based on the output of the oscillation circuit including low temperature polysilicon thin film transistors formed on an insulation substrate;
the oscillation circuit has
a pulse generation portion including an oscillator for generating pulse signals having a frequency variation and
a frequency variation correction portion for outputting output rectangular waves of the pulse generation portion suppressed to a predetermined frequency range, wherein
the frequency variation correction portion includes
an input pulse counter comprising n number of counters cascade connected and counting numbers of high level and low level periods of rectangular waves input from the pulse generation portion in a comparison input period,
a counter value comparison circuit for generating a selection signal for selecting a last output from an any counter among the cascade connected counters when the input pulse counter counts any number, and
an output selection circuit for receiving the selection signal and outputting a corresponding counter value.

14. An electronic apparatus as set forth in claim 13, wherein the input pulse counter starts a count operation by a release of reset and ends the variation correction at the time of the next reset.

15. An electronic apparatus as set forth in claim 13, wherein frequency correction results with respect to input rectangular waves are held until the reset is applied.

16. An electronic apparatus as set forth in claim 13, wherein, according to a combination of logics in the counter value comparison circuit, determination of the lowest/highest value of the output frequency and ratio adjustment thereof are possible.
